# EUROPEAN PATENT SPECIFICATION

(11) **EP 3 584 130 B1**
(45) Date of publication and mention of the grant of the patent: **03.09.2025**
(21) Application number: 18753543.0
(22) Date of filing: 13.02.2018
(51) Int. Cl.: B60T 8/36, H05K 5/06, F16B 11/00, H05K 5/02

(54) **VEHICLE BRAKE FLUID PRESSURE CONTROL DEVICE**
STEUERUNGSVORRICHTUNG FÜR BREMSFLÜSSIGKEITSDRUCK EINES FAHRZEUGS
DISPOSITIF DE COMMANDE DE PRESSION DE LIQUIDE DE FREIN DE VÉHICULE

(30) Priority: 17.02.2017 JP 2017028510
(43) Date of publication of application: 25.12.2019
(60) Divisional application: 22200556.3
(73) Proprietor: Astemo, Ltd., Tokyo 100-0004 (JP)
(72) Inventor: CHIBA, Kentaro, Tomi-city Nagano 389-0514 (JP); OBINATA, Naoto, Tomi-city Nagano 389-0514 (JP)
(74) Representative: Hoefer & Partner Patentanwälte mbB
(86) International application number: PCT/JP2018/004782
(87) International publication number: WO 2018/151063

(56) References cited:
- WO-A1-2011/114614
- JP-B2- 3 627 485
- JP-U- S6 426 885
- JP-U- S6 426 885
- US-A- 5 358 773
- US-A- 6 079 798
- US-A1- 2016 082 908

## Description

### Technical Field

The present invention relates to a structure of a control device that performs antilocking braking control of a vehicle.

### Background Art

The sealing structure of a control device is disclosed as, for example, the technique in Japanese Patent No. 5526096 (referred to below as PTL 1). In the sealing structure disclosed in PTL 1, a groove is provided in a housing, a protrusion to be inserted into the groove is provided in a cover, and the groove is filled with a sealing agent. The sealing structure is completed by inserting the protrusion into the groove in this state.

In the case of this seal structure, the sealing agent or the adhesive may protrude onto the outer surface of the housing.

If the sealing agent or the adhesive protrudes onto the outer surface, a process for wiping the sealing agent or the adhesive is necessary, thereby increasing the production cost.

When the cover is bonded to the housing while achieving reduction in the production cost, the structure capable of preventing the adhesive from protruding onto the outer surface of the housing while improving an adhesive strength is necessary.

### Citation List

### Patent Literature

PTL 1: Japanese Patent No. 5526096

Prior art document JP 3 627485 B2 refers to a pressure control device for a vehicle which is configured to inhibit a displacement of a coil terminal part and a connecting member to each other by forming a magnetic path with upper and lower yokes mounted around bobbins on which a coil is wound in an electromagnetic coil part, mounting an elastic body between the lower yoke and the bobbin, and bringing the bobbin into contact with a part of a housing to inhibit the movement thereof. The underlying coils are wound on the electromagnetic coil parts and the electromagnetic coil parts comprise the bobbins, the upper yokes, and the lower yokes mounted around the bobbins for forming a magnetic path, and elastic bodies mounted between the lower yokes and the bobbins. The elastic bodies are, for example, the plate springs, and bring the bobbins into contact with a part of a coil housing. By the pressure of this elastic bodies, the movement in a vertical direction of the bobbins is inhibited. Further a part of the coil housing exists between the upper yokes and the bobbins. Whereby the stress in the electrical connection part of the electromagnetic coil part can be mitigated.
Prior art document US 6 079 798 A shows a a brake pressure control device having a reliable sealing effect which lengthens the life span of the electrical and electronic parts. A solenoid valve cover includes a bowl-shaped cover housing and a valve cover. A bottom surface of the cover housing is inserted over a valve assembly of the solenoid valve in order to attach to the installation surface of a housing of a hydraulic unit. An attaching device of a coil assembly is provided around the valve assembly in the cover housing, and is commonly used for also attaching the cover housing.
Prior art document US 2016 / 082 908 A1 describes an electronic control apparatus that includes an electric motor including a rotor and a stator; a circuit board configured to drivingly control the electric motor; and a housing unit accommodating the electric motor and the circuit board. A vehicle-body attaching portion of the housing unit is attached and fixed to a vehicle body. The vehicle-body attaching portion is located on one side of the rotor with respect to an extending direction of the rotor. At least one of both surfaces of the circuit board is a component-mounting surface. The circuit board is fixed to the housing unit in a state where both surfaces of the circuit board extend along the rotor of the electric motor. A large-size electronic component is mounted on a vehicle-body-attaching-portion-side portion of a peripheral portion of the component-mounting surface which is close to the vehicle-body attaching portion.
Prior art document US 5 358 773 A discloses a structure having a surface to which an adhesive, fed from a movable nozzle, is applied before connecting an object to the surface. The structure includes a guide groove provided on the surface in which the adhesive is to be applied, such that the nozzle may be moved along the guide groove to introduce the adhesive into the groove.
Prior art document JP S64 26885 U proposes an alternative structure, wherein a sealing material is applied to circumferential grooves formed in main bodies to be attached to each other.

### Summary of Invention

### Technical Problem

An object of the invention is to provide a structure capable of preventing an adhesive from protruding onto an outer surface of a housing while improving an adhesive strength when a cover is coupled to the housing in a vehicle brake fluid pressure control device.

### Solution to Problem

The object underlying the present invention is achieved by a vehicle brake fluid pressure control device according to independent claim 1.
According to claim 1, there is provided a vehicle brake fluid pressure control device,
including:
   - a base body provided with a brake fluid line;
   - a housing in which a control board is accommodated; and
   - a cover that is attached to the housing and covers the control board,
in which:
   - the housing has an opening on a front side and an opening on a back side and has a peripheral wall part in which the control board is accommodated,
   - the peripheral wall part of the housing has an attachment part to which the cover is attached,
   - the cover has a protrusion extending toward the attachment part,
   - the attachment part of the peripheral wall part has a top groove that is filled with an adhesive and into which the protrusion is inserted,
   - the cover comes in contact with the attachment part at a contacting part present on an outer side of the protrusion when the cover is attached to the housing,
   - at least one of the top groove of the attachment part and a portion between the contacting part and the protrusion of the cover has a collecting groove in which an excess portion of the adhesive is collected when the cover is attached to the housing
In addition and according to the invention, the protrusion further includes a projection that comes in contact with a surface of the top groove into which the protrusion is inserted.

The following measures may additionally be taken, too:
- the housing may have a flange that comes in contact with the base body,
- the flange may overhang toward an outer side from a peripheral wall part of the housing,
- the flange may have a lower groove to be filled with an adhesive,
- a surface of the flange close to the base body may be divided by the lower groove into an outer-side surface on an outer side of the lower groove and an inner-side surface on an inner side of the lower groove,
- a small gap may be ensured between the inner-side surface and the base body when the outer-side surface comes in contact with the base body, and
- an excess portion of the adhesive may flow into the small gap.

Furthermore, a surface that forms the lower groove may be a coarse surface.

### Advantageous Effects of Invention

According to claim 1, the protrusion of the cover is inserted into the adhesive having filled the top groove. Since the adhesive is surely attached to the protrusion, the adhesive strength is improved.
Since the adhesive flows into the collecting groove when the cover is attached to the housing, the adhesive does not protrude onto the outer surface of the housing.

In addition the projection provided on the protrusion of the cover comes into slidable contact with the top groove of the attachment part, so a rattle can be prevented when the cover is attached to the housing.

In case of the above flange configuration, the adhesive is inserted into the small gap when the housing is assembled to the base body. Since the excess portion of the adhesive is collected in the small gap, there is no concern that the adhesive enters the inside of the housing.

In case of the above coarse-surface configuration, an anchor effect of putting the adhesive onto the coarse surface is exerted. This anchor effect prevents the adhesive from peeling from the surface of the lower groove, thereby improving the bonding performance of the adhesive.

### Brief Description of Drawings

[Fig. 1] Fig. 1 is a basic structure diagram illustrating a dual-circuit vehicle brake fluid pressure control device according to the invention.
[Fig. 2] Fig. 2 is a cross sectional view illustrating the dual-circuit vehicle brake fluid pressure control device.
[Fig. 3] Fig. 3 is an enlarged view (used to describe an adhesive collecting part) illustrating a section 3c in Fig. 2.
[Fig. 4] Fig. 4 illustrates a modification of the adhesive collecting part.
[Fig. 5] Fig. 5 illustrates another modification of the adhesive collecting part.
[Fig. 6] Fig. 6 is a perspective view illustrating main parts of a housing and a cover.
[Fig. 7] Fig. 7 is an enlarged view (used to describe a coarse surface) illustrating a section 7b in Fig. 2.

### Description of Embodiments

An embodiment of the invention will be described with reference to the attached drawings.

It is assumed that a control device that controls the fluid pressures of a front wheel brake and a rear wheel brake is referred to as a dual-circuit vehicle brake fluid pressure control device and a control device that controls the fluid pressure of one of the front wheel brake and the rear wheel brake is referred to as a single-circuit vehicle brake fluid pressure control device.

### Embodiment

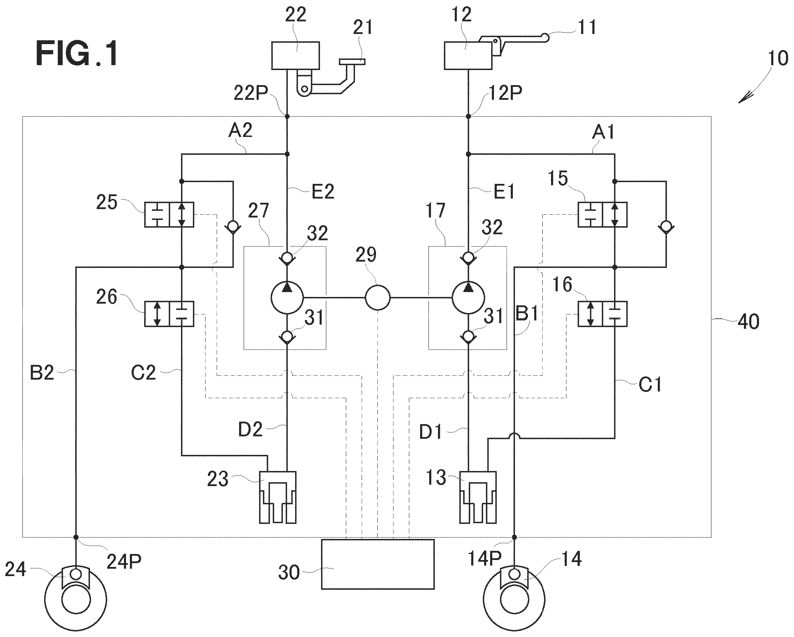

As illustrated in Fig. 1, a dual-circuit vehicle brake fluid pressure control device 10 includes a first master cylinder 12, a first reservoir 13, a first inlet control valve 15 that is a normally open solenoid valve, a first outlet control valve 16 that is a normally closed solenoid valve, a first pump 17, a second master cylinder 22, a second reservoir 23, a second inlet control valve 25 that is a normally open solenoid valve, a second outlet control valve 26 that is a normally closed solenoid valve, a second pump 27, a motor 29 that drives the first and second pumps 17 and 27, a control device 30 that controls the driving of the motor 29 and controls the opening and closing of the first and second inlet control valves 15 and 25 and the first and second outlet control valves 16 and 26, brake fluid lines A1, B1, C1, D1, and E1 of a first circuit and brake fluid lines A2, B2, C2, D2, and E2 of a second circuit that are provided in a base body 40 and through which a brake fluid flows.

The first master cylinder 12 pressurizes a hydraulic fluid in accordance with an operation of a brake lever 11 to produce a fluid pressure.

The first reservoir 13 temporarily reserves the hydraulic fluid released from a front wheel brake caliper 14.

The first inlet valve 15 and the first outlet control valve 16 are assembly components provided between the first master cylinder 12 and the front wheel brake caliper 14.

The first pump 17 is an assembly component that sucks the hydraulic fluid reserved in the first reservoir 13 and returns the hydraulic fluid to the first master cylinder 12.

The second master cylinder 22 pressurizes the hydraulic fluid in accordance with an operation of a brake pedal 21 to produce a fluid pressure.

The second reservoir 23 temporarily reserves the hydraulic fluid released from a rear wheel brake caliper 24.

The second inlet control valve 25 and the second outlet control valve 26 are assembly components provided between the second master cylinder 22 and the rear wheel brake caliper 24.

The second pump 27 is an assembly component that sucks the hydraulic fluid reserved in the second reservoir 23 and returns the hydraulic fluid to the second master cylinder 22.

The suction sides of the first and second pumps 17 and 27 are provided with suction valves 31 and the discharge sides are provided with discharge valves 32.

In addition, the base body 40 includes an inlet port 12P to which the fluid line (brake piping) extending from the first master cylinder 12 is connected, an inlet port 22P to which the fluid line (brake piping) extending from the second master cylinder 22 is connected, an outlet port 14P to which the fluid line (brake piping) extending to the front wheel brake caliper 14 is connected, and an outlet port 24P to which the fluid line (brake piping) extending to the rear wheel brake caliper 24 is connected.

The brake fluid line A1 is the fluid line from the inlet port 12P to the first inlet control valve 15 and the brake fluid line B1 is the fluid line from the first inlet control valve 15 to the outlet port 14P.

The brake fluid line C1 is the fluid line from the brake fluid line B1 to the first reservoir 13 and the brake fluid line D1 is the fluid line from the first reservoir 13 to the first pump 17.

The brake fluid line E1 is the fluid line from the first pump 17 to the brake fluid line A1.

The brake fluid lines A2, B2, C2, D2, and E2 are not described to eliminate duplicate descriptions.

Next, the operation of the vehicle brake fluid pressure control device 10 will be described. It should be noted here that since the operation of the first circuit from the brake lever 11 to the front wheel brake caliper 14 is the same as the operation of the second circuit from the brake pedal 21 to the rear wheel brake caliper 24, only the first circuit will be described.

- ABS non-operating state: When there is no concern that the front wheels lock, the control device 30 stops the first pump 17, opens the first inlet control valve 15, and closes the first outlet control valve 16. When the brake lever 11 is operated to the braking side in this state, the fluid pressure of the first master cylinder 12 increases and this fluid pressure is transferred to the front wheel brake caliper 14 via the first inlet control valve 15.
- ABS (reducing pressure mode): When the front wheels almost lock, the control device 30 closes the first inlet control valve 15 and opens the first outlet control valve 16. The fluid pressure in the front wheel brake caliper 14 is released to the first reservoir 13 via the first outlet control valve 16. This reduces the brake fluid pressure of the front wheel brake caliper 14.
- ABS (hold mode): The control device 30 closes both the first inlet control valve 15 and the first outlet control valve 16. This holds the brake fluid pressure of the front wheel brake caliper 14 at a constant value.
- ABS (increasing pressure mode): When the brake fluid pressure is increased, the control device 30 opens the first inlet control valve 15 and closes the first outlet control valve 16. This transfers the fluid pressure produced in the master cylinder 12 to the front wheel brake caliper 14. As a result, the brake fluid pressure of the front wheel brake caliper 14 is increased.

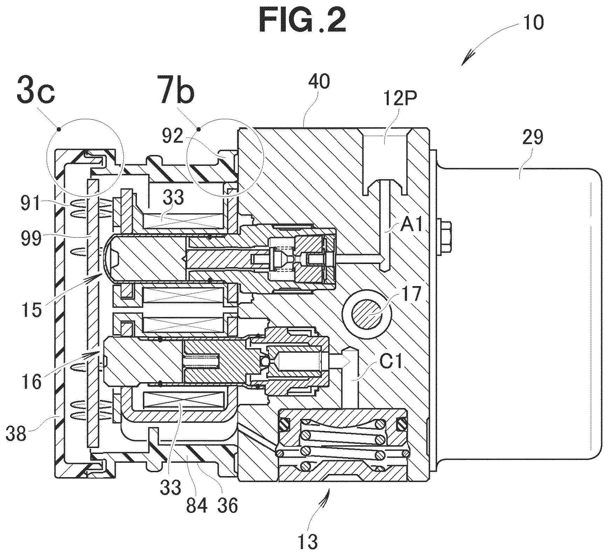

As illustrated in Fig. 2, the solenoid valve 15 as the first inlet control valve and the solenoid valve 16 as the first outlet control valve are attached to the base body 40. In addition, the base body 40 has the first reservoir 13 therein, the brake fluid line A1 and C1 and the like, and the first pump 17 between the brake fluid line A1 and the brake fluid line C1.

Approximately the halves of the solenoid valve 15 and the solenoid valve 16 in the axial direction project from the base body 40 and these projecting parts are accommodated in a resinous component 36. The resinous component 36 is read as the housing 36 below. The solenoid valve 15 and the solenoid valve 16 have electromagnetic coils 33 for driving.

The housing 36 has openings on the front side (side of a cover 38) and the back side (side of the base body 40) and has a peripheral wall part 84 in which a control board 99 is accommodated.

The control board 99 is disposed in the housing 36 and the control board 99 is electrically connected to the electromagnetic coils 33 via terminals 91.

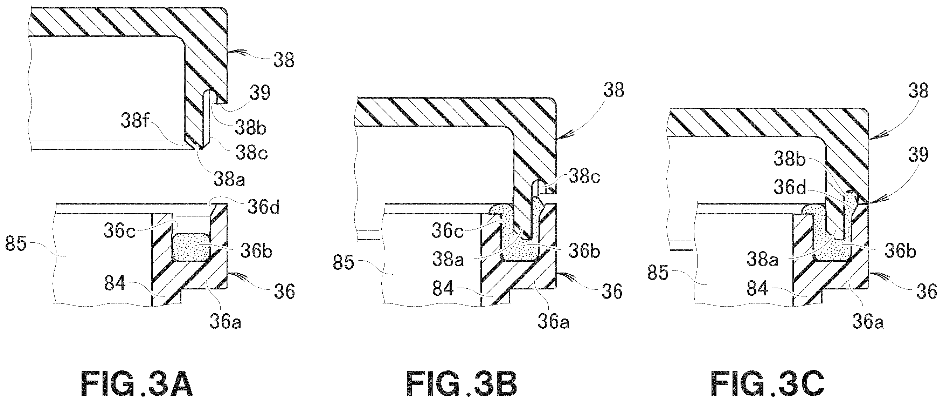

An enlarged view of a section 3c in Fig. 2 is illustrated in Fig. 3(c).

As illustrated in Fig. 3(a), the cover 38 to be provided for the housing 36 has an insertion protrusion 38a projecting in one direction (toward the housing 36) in the outer periphery of the cover 38, a collecting groove 38b in which resin is collected in this insertion protrusion 38a, and projections 38c extending upward and downward. In addition, an attachment part 36a to which the cover 38 is attached is formed in the peripheral wall part 84 that surrounds a board accommodation part 85, and the attachment part 36a is provided with a top groove 36c that is filled with an adhesive 36b and into which the insertion protrusion 38a is inserted.

The cover 38 has, on the outer side of the insertion protrusion 38a, a contacting part 39 that comes in contact with the attachment part 36a of the housing 36.

The insertion protrusion 38a is provided with the projections 38c so that the projections 38c make slidable contact with the inner surface of the top groove 36c when the cover 38 is attached. When the cover 38 tries to move in the horizontal direction, the cover 38 cannot move in the horizontal direction since the projections 38c come in contact with the inner surface of the top groove 36c. As a result, it is possible to prevent a rattle when the cover 38 is attached to the housing 36.

A tapered surface 38f is provided at the lower end part of the insertion protrusion 38a to form the lower end of the insertion protrusion 38a in a pointed shape. This shape enables the insertion protrusion 38a to be smoothly accommodated in the groove 36c and to smoothly thrust the adhesive 36b.

When the adhesive 36b is placed in the top groove 36c and the cover 38 is lowered, the insertion protrusion 38a is inserted into the top groove 36c. As illustrated in Fig. 3(b), the adhesive 36b is pushed by the insertion protrusion 38a and partially moves to the outside of the peripheral wall part 84 or the inside of the peripheral wall part 84.

As illustrated in Fig. 3(c), since the adhesive 36b flows into the collecting groove 38b, the adhesive 36b does not protrude onto the outer surface of the housing 36.

It is desirable to increase the cross sectional areas of the collecting groove 38b and a second collecting groove 36d by providing the second collecting groove 36d in the housing 36.

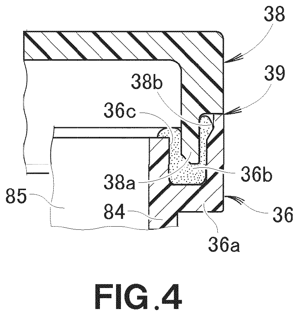

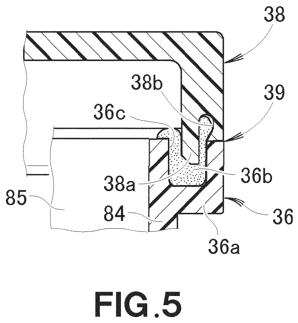

Next, modifications will be described with reference to Fig. 4 and Fig. 5.

As illustrated in Fig. 4, the collecting groove 38b may be formed in the top groove 36c in the attachment part 36a of the housing 36. Since the structure other than this is the same as in Fig. 3, reference numerals in Fig. 3 are used and detailed descriptions are omitted.

As illustrated in Fig. 5, the collecting groove 38b may be formed in the cover 38. Since the structure other than this is the same as in Fig. 3, reference numerals in Fig. 3 are used and detailed descriptions are omitted.

As described above, the collecting groove 38b may be provided in the housing 36, provided in the cover 38, or provided across the housing 36 and the cover 38.

That is, the collecting groove 38b may be provided in the top groove 36c of the attachment part 36a of the housing 36 or provided between the insertion protrusion 38a of the cover 38 and the contacting part 39.

The collecting groove 38b is provided in at least one of a portion between the insertion protrusion 38a of the cover 38 and the contacting part 39 and the top groove 36c of the attachment part 36a.

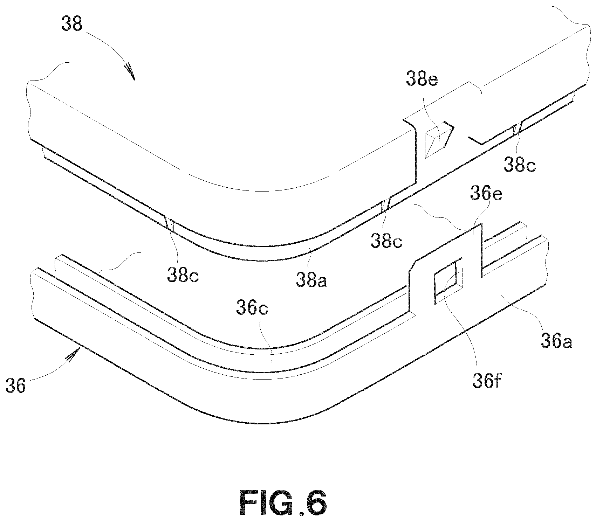

As illustrated in Fig. 6, a projecting part 36e is formed so as to project from the housing 36 toward the cover 38. This projecting part 36e is provided on the attachment part 36a in which the top groove 36c for accommodating the insertion protrusion 38a of the cover 38 is formed. This projecting part 36e fixes (properly speaking, temporarily fix the cover for bonding) the cover 38. The projecting part 36e is referred to below as the fixing part 36e.

This fixing part 36e is a gate-shaped member extending from the attachment part 36a toward the cover 38. A projection 38e provided in the cover 38 is locked to a rectangular hole 36f of the fixing part 36e to fix (temporarily fix) the cover 38.

The cover 38 has the plurality of projections 38c arranged at a predetermined pitch and these projections 38c come in contact with the outer-side wall surface of the top groove 36c, so the cover 38 is attached to the housing 36 without being horizontally moved or rotated.

It should be noted here that the projections 38c are provided on the outer surface of the cover 38 in the embodiment, but the projections 38c may be provided on the inner surface of the cover 38. In this case, the projections 38c come in contact with the inner-side wall surface of the top groove 36c.

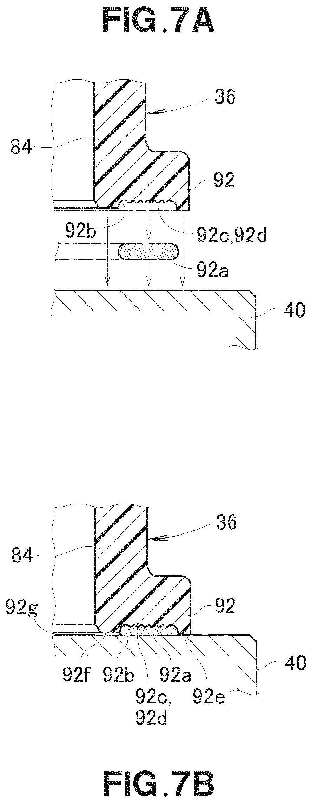

An enlarged view of a section 7b in Fig. 2 is illustrated in Fig. 7(b) and an exploded view of Fig. 7(b) is illustrated in Fig. 7(a).

As illustrated in Fig. 7(a), the peripheral wall part 84 of the housing 36 has a flange 92 that comes in contact with the base body 40, and the flange 92 overhangs toward the outer side from the peripheral wall part 84 and has a lower groove 92b for collecting an adhesive 92a in a surface close to the base body 40. In addition, a bottom surface 92c of the lower groove 92b is a coarse surface 92d.

The housing 36 is brought in contact with the base body 40 so that the adhesive 92a is accommodated in the lower groove 92b.

This bonds the adhesive 92a to the coarse surface 92d due to an anchor effect as illustrated in Fig. 7(b) and firmly bonds the housing 36 to the base body 40, thereby preventing interface peeling.

In addition, the surface of the flange 92 close to the base body 40 is divided by the lower groove 92b into an outer-side surface 92e and an inner-side surface 92f in Fig. 7(b) and a small gap 92g is provided between the inner-side surface 92f and the base body 40.

Since the excess portion of the adhesive 92a flows into the small gap 92g, there is no concern that the adhesive 92a enters the inside of the housing 36.

Although not illustrated, the invention is also applicable to a single-circuit vehicle brake fluid pressure control device.

It should be noted here that the invention is preferable to a motorcycle, but the invention is also applicable to a three-wheeled cycle and application to a general vehicle has no difficulty.

### Industrial Applicability

The invention is preferable to a motorcycle.

### Reference Signs List

10: vehicle brake fluid pressure control device
36: housing
36a: attachment part of housing in contact with base body
36b: adhesive
36c: top groove
38: cover
38a: protrusion (insertion protrusion) provided on cover
38b: collecting groove provided in cover
38c: projection provided on cover
39: contacting part
40: base body
84: peripheral wall part
92: flange
92a: adhesive
92b: lower groove
92c: bottom surface of lower groove
92d: coarse surface
92e: outer-side surface
92f: inner-side surface
92g: small gap ensured between inner-side surface and base body
99: control board
A1 to E1, A2 to E2: brake fluid line

## Claims

1. A vehicle brake fluid pressure control device (10),
comprising:
- a base body (40) provided with a brake fluid line (A1 - E2);
- a housing (36) in which a control board (99) is accommodated; and
- a cover (38) that is attached to the housing (36) and covers the control board (99),
**characterized in that**:
- the housing (36) has an opening on a front side and an opening on a back side and has a peripheral wall part (84) in which the control board (99) is accommodated,
- the peripheral wall part (84) of the housing (36) has an attachment part (36a) to which the cover (38) is attached,
- the cover (38) has a protrusion (38a) extending toward the attachment part (36a),
- the attachment part (36a) of the peripheral wall part (84) has a top groove (36c) that is filled with an adhesive (36b) and into which the protrusion (38a) is inserted,
- the cover (38) comes in contact with the attachment part (36a) at a contacting part (39) present on an outer side of the protrusion (38a) when the cover (38) is attached to the housing (36),
- at least one of the top groove (36c) of the attachment part (36a) and a portion between the contacting part (39) and the protrusion (38a) of the cover (38) has a collecting groove (38b) in which an excess portion of the adhesive (36b) is collected when the cover (38) is attached to the housing (36), and
- the protrusion (38a) further includes projections (38c) that come in contact with a surface of the top groove (36c) into which the protrusion (38a) is inserted.

## Patentansprüche

1. Fahrzeugbremsflüssigkeitsdrucksteuervorrichtung (10),
umfassend:
- einen Grundkörper (40), der mit einer Bremsflüssigkeitsleitung (A1 - E2) versehen ist;
- ein Gehäuse (36), in dem eine Steuerplatine (99) untergebracht ist; und
- eine Abdeckung (38), die an dem Gehäuse (36) angebracht ist und die Steuerplatine (99) abdeckt,
**dadurch gekennzeichnet, dass:**
- das Gehäuse (36) eine Öffnung an einer Vorderseite und eine Öffnung an einer Rückseite aufweist und einen Umfangswandteil (84) aufweist, in dem die Steuerplatine (99) untergebracht ist,
- der Umfangswandteil (84) des Gehäuses (36) einen Anbringungsteil (36a) aufweist, an dem die Abdeckung (38) angebracht ist,
- die Abdeckung (38) einen Vorsprung (38a) aufweist, der sich zu dem Anbringungsteil (36a) erstreckt,
- der Anbringungsteil (36a) des Umfangswandteils (84) eine obere Nut (36c) aufweist, die mit einem Klebstoff (36b) gefüllt ist und in die der Vorsprung (38a) eingesetzt ist,
- die Abdeckung (38) mit dem Anbringungsteil (36a) an einem Kontaktteil (39) in Kontakt kommt, der an einer Außenseite des Vorsprungs (38a) vorhanden ist, wenn die Abdeckung (38) an dem Gehäuse (36) angebracht ist,
- mindestens eine von der oberen Nut (36c) des Anbringungsteils (36a) und einem Abschnitt zwischen dem Kontaktteil (39) und dem Vorsprung (38a) der Abdeckung (38) eine Sammelnut (38b) aufweist, in der ein überschüssiger Abschnitt des Klebstoffs (36b) gesammelt wird, wenn die Abdeckung (38) an dem Gehäuse (36) angebracht ist, und
- der Vorsprung (38a) ferner Vorsprünge (38c) aufweist, die mit einer Oberfläche der oberen Nut (36c) in Kontakt kommen, in die der Vorsprung (38a) eingesetzt ist.

## Revendications

1. Dispositif de commande de pression de liquide de frein de véhicule (10),
comprenant :
- un corps de base (40) pourvu d'une conduite de liquide de frein (A1 - E2) ;
- un boîtier (36) dans lequel une carte de commande (99) est logée ; et
- un couvercle (38) qui est fixé au boîtier (36) et recouvre la carte de commande (99),
**caractérisé en ce que** :
- le boîtier (36) a une ouverture sur un côté avant et une ouverture sur un côté arrière et a une partie de paroi périphérique (84) dans laquelle la carte de commande (99) est logée,
- la partie de paroi périphérique (84) du boîtier (36) a une partie de fixation (36a) à laquelle le couvercle (38) est fixé,
- le couvercle (38) a une saillie (38a) s'étendant vers la partie de fixation (36a),
- la partie de fixation (36a) de la partie de paroi périphérique (84) a une rainure supérieure (36c) qui est remplie d'un adhésif (36b) et dans laquelle la saillie (38a) est insérée,
- le couvercle (38) vient en contact avec la partie de fixation (36a) au niveau d'une partie de contact (39) présente sur un côté externe de la saillie (38a) lorsque le couvercle (38) est fixé au boîtier (36),
- au moins l'une de la rainure supérieure (36c) de la partie de fixation (36a) et d'une partie entre la partie de contact (39) et la saillie (38a) du couvercle (38) a une rainure de collecte (38b) dans laquelle une partie en excès de l'adhésif (36b) est collectée lorsque le couvercle (38) est fixé au boîtier (36), et
- la saillie (38a) comprend en outre des saillies (38c) qui viennent en contact avec une surface de la rainure supérieure (36c) dans laquelle la saillie (38a) est insérée.
